# EUROPEAN PATENT APPLICATION

(11) **EP 4 704 338 A1**
(43) Date of publication of application: **04.03.2026**
(21) Application number: 24797058.5
(22) Date of filing: 24.04.2024
(51) Int. Cl.: H03F 3/26, H02M 1/08, H03K 17/691, H03K 19/0175, H04L 25/02, H04L 25/03

(54) **GATE DRIVE CIRCUIT**

(30) Priority: 28.04.2023 JP 2023074978
(71) Applicant: Sansha Electric Manufacturing Co., Ltd., Osaka 533-0031 (JP)
(72) Inventor: FUKAI Masashi, Osaka-shi,Osaka 533-0031 (JP); NISHIMURA Naoki, Osaka-shi,Osaka 533-0031 (JP)
(74) Representative: Stöckeler, Ferdinand
(86) International application number: PCT/JP2024/016058
(87) International publication number: WO 2024/225312

(57) **Abstract**

A gate drive circuit 100 includes: a signal conversion circuit 2 configured to convert a gate control signal 11 into a differential signal 21 including a positive signal 21A and a negative signal 21B; a first pulse transformer 3 including a primary winding and a secondary winding that have neutral points respectively, the primary winding including the neutral point set to have the potential of the first ground, the primary winding having both ends to which the positive signal 21A and the negative signal 21B are input respectively; an input difference voltage generation circuit 6 configured to generate a pair of input difference voltages 22A and 22B at both ends of a pair of resistance elements on the basis of the voltage at both ends of the secondary winding of the first pulse transformer 3; a differential amplifier circuit 7 configured to differentially amplify the pair of input difference voltages 22A and 22B and output a pair of output difference voltages 23A and 23B; and a gate drive signal generation circuit 9 configured to generate a gate drive signal 25A on the basis of the pair of output difference voltages 23A and 23B.

## Description

### Technical Field

The present invention relates to a gate drive circuit.

### Background Art

This application claims the benefit of foreign priority to Japanese Patent Application No. JP2023-074978, field April 28, 2023, which is incorporated by reference in its entirety.

It is conventionally known that in a gate driving circuit that drives a switching element that operates in a floating state, the input side and the output side are insulated from each other. In such a case, common mode noise may occur due to, for example, switching of the switching element. In order to cope with this common mode noise, various proposals have been made. For example, in the gate driving circuit of Patent Literature 1, the input side and the output side are insulated from each other by a pulse transformer, the input side is grounded to a first ground potential point, and the output side is grounded to a second ground potential point. Then, a primary-side gate drive signal is input to a primary winding of the pulse transformer, and the output on the secondary side of the pulse transformer is differentially amplified by a comparator and output as a secondary-side gate drive signal. Furthermore, an electrostatic shield plate grounded to the second ground potential point is disposed between the primary winding and the secondary winding of the pulse transformer.

### Citation List

### Patent Literature

Patent Literature 1: JP 2013-074079 A

### Summary of Invention

### Technical Problem

The gate driving circuit of Patent Literature 1 can remove common mode noise superimposed on the output side, but cannot remove common mode noise superimposed on the input side.

The present invention has been made to solve such a problem, and an object of the present invention is to provide a gate drive circuit capable of removing common mode noise superimposed on the output side and the input side.

### Solution to Problem

In order to achieve the above object, a gate drive circuit according to an aspect of the present disclosure includes: a signal conversion circuit configured to operate with a potential of a first ground as a reference potential and convert a gate control signal that is a single-ended signal into a differential signal including a positive signal and a negative signal that have a signal level difference corresponding to the gate control signal; a first pulse transformer including a primary winding and a secondary winding that are electrically insulated from each other and have neutral points respectively, the primary winding including the neutral point set to have the potential of the first ground, the primary winding having both ends to which the positive signal and the negative signal of the differential signal are input respectively; an input difference voltage generation circuit including a pair of resistance elements connected in series to each other, the pair of resistance elements having both ends and a connection point that are respectively connected to both ends and the neutral point of the secondary winding of the first pulse transformer directly electrically or via a transmission cable and a second pulse transformer, the input difference voltage generation circuit configured to generate a pair of input difference voltages based on a potential of the connection point at the both ends of the pair of resistance elements; a differential amplifier circuit that is electrically connected to the input difference voltage generation circuit, the differential amplifier circuit configured to differentially amplify the pair of input difference voltages and output a pair of output difference voltages; and a gate drive signal generation circuit that is electrically connected to the differential amplifier circuit, the gate drive signal generation circuit configured to generate a gate drive signal that is a single-ended signal based on a predetermined potential on the basis of the pair of output difference voltages and output the gate drive signal to a switching element that operates with a potential of a second ground as a reference.

### Advantageous Effects of Invention

The present invention has an effect that a gate drive circuit can be provided that is capable of removing common mode noise superimposed on the output side and the input side.

### Brief Description of Drawings

FIG. 1 is a circuit diagram illustrating a configuration of a push-pull amplifier circuit using a gate drive circuit of the present disclosure.
FIG. 2A is a block diagram illustrating a first configuration example of the gate drive circuit of FIG. 1.
FIG. 2B is a block diagram illustrating a second configuration example of the gate drive circuit of FIG. 1.
FIG. 3 is a circuit diagram illustrating an example of a specific circuit configuration of the first configuration example of the gate drive circuit of FIG. 2A.
FIG. 4A is a waveform diagram illustrating a waveform of a differential signal on which common mode noise is superimposed.
FIG. 4B is a waveform diagram illustrating a waveform of a differential signal induced in a first pulse transformer by the differential signal of FIG. 4A.
FIG. 4C is a waveform diagram illustrating a waveform of an input difference voltage generated by an input difference voltage generation circuit from a signal derived from the differential signal induced in the first pulse transformer of FIG. 4B.
FIG. 5 is a circuit diagram illustrating an operation of a switching power supply using a push-pull amplifier circuit of FIG. 3.
FIG. 6 is a schematic diagram illustrating switching noise generated by a switching module of FIG. 5.

### Description of Embodiments

A gate drive circuit according to an aspect of the present disclosure includes: a signal conversion circuit configured to operate with a potential of a first ground as a reference potential and convert a gate control signal that is a single-ended signal into a differential signal including a positive signal and a negative signal that have a signal level difference corresponding to the gate control signal; a first pulse transformer including a primary winding and a secondary winding that are electrically insulated from each other and have neutral points respectively, the primary winding including the neutral point set to have the potential of the first ground, the primary winding having both ends to which the positive signal and the negative signal of the differential signal are input respectively; an input difference voltage generation circuit including a pair of resistance elements connected in series to each other, the pair of resistance elements having both ends and a connection point that are respectively connected to both ends and the neutral point of the secondary winding of the first pulse transformer directly electrically or via a transmission cable and a second pulse transformer, the input difference voltage generation circuit configured to generate a pair of input difference voltages based on a potential of the connection point at the both ends of the pair of resistance elements; a differential amplifier circuit that is electrically connected to the input difference voltage generation circuit, the differential amplifier circuit configured to differentially amplify the pair of input difference voltages and output a pair of output difference voltages; and a gate drive signal generation circuit that is electrically connected to the differential amplifier circuit, the gate drive signal generation circuit configured to generate a gate drive signal that is a single-ended signal based on a predetermined potential on the basis of the pair of output difference voltages and output the gate drive signal to a switching element that operates with a potential of a second ground as a reference.

According to this configuration, the input side and the output side of the gate drive circuit are insulated from each other by the first pulse transformer, the output side is connected to the switching element while the input side is based on the potential of the first ground, and thus a floating state based on the potential of the second ground is obtained. In this state, the signal conversion circuit converts the gate control signal that is a single-ended signal into the differential signal including the positive signal and the negative signal having a signal level difference corresponding to the gate control signal, and the primary winding of the first pulse transformer includes the neutral point set to have the potential of the first ground, and has the both ends to which the differential signal is input. Thus, the positive signal and the negative signal are converted into a pair of single-ended voltage signals that are induced in the same winding of the transformer as the voltages at both ends, each have twice the amplitude, and have opposite phases (opposite in positive and negative) from each other. Therefore, in a case where common mode noise is superimposed on each of the positive signal and the negative signal on the input side, the common mode noise of the positive signal and the common mode noise of the negative signal are opposite in positive and negative (plus and minus), and thus canceled and removed in the first pulse transformer.

On the output side, the pair of resistance elements of the input difference voltage generation circuit have the both ends and the connection point that are respectively connected to the both ends and the neutral point of the secondary winding of the first pulse transformer directly electrically or via the transmission cable and the second pulse transformer, a pair of input difference voltages based on the potential of the connection point is generated at the both ends of the pair of resistance elements, and the differential amplifier circuit differentially amplifies the pair of input difference voltages. Therefore, on the output side, in a case where common mode noise is superimposed on a pair of wirings connected to the both ends of the secondary winding of the first pulse transformer directly or indirectly, the common mode noise of the pair of wirings is opposite in positive and negative in the pair of input difference voltages generated by the input difference voltage generation circuit, and removed by the differential amplifier circuit. Furthermore, the load current of the first pulse transformer flows through the pair of resistance elements of the input difference voltage generation circuit, and thus the impedance of the transmission path of the differential signal is reduced to improve the capability to remove common mode noise.

As a result, a gate drive circuit can be provided that is capable of removing common mode noise superimposed on the output side and the input side.

The second pulse transformer may include a primary winding and a secondary winding that are electrically insulated from each other and have neutral points respectively, the primary winding having both ends and the neutral point that are respectively connected to the both ends and the neutral point of the secondary winding of the first pulse transformer electrically via the transmission cable, and in the input difference voltage generation circuit, the both ends and the connection point of the pair of resistance elements may be respectively connected to the both ends and the neutral point of the secondary winding of the second pulse transformer.

According to this configuration, in a case where common mode noise is superimposed on the secondary winding of the first pulse transformer and the transmission cable, the second pulse transformer can remove the common mode noise as in the case of the first pulse transformer. As a result, a control device that generates the gate control signal can be disposed away from the switching element by lengthening the transmission cable, and a computer included in the control device can be suitably protected from noise generated by a switching operation of the switching element.

Two of the switching elements may constitute a first switching element and a second switching element that are push-pull connected to each other, the gate drive circuit may include a first differential amplifier circuit and a second differential amplifier circuit as the differential amplifier circuit, the gate drive circuit may include a first gate drive signal generation circuit and a second gate drive signal generation circuit as the gate drive signal generation circuit, the first differential amplifier circuit may be a circuit that is electrically connected to the input difference voltage generation circuit, differentially amplifies the pair of input difference voltages, and outputs a pair of first output difference voltages having a high potential, the second differential amplifier circuit may be a circuit that is electrically connected to the input difference voltage generation circuit, differentially amplifies the pair of input difference voltages, and outputs a pair of second output difference voltages lower than the pair of first output difference voltages and having a low potential, the first gate drive signal generation circuit may be a circuit that is electrically connected to the first differential amplifier circuit, generates a first gate drive signal being the gate drive signal based on a positive potential on a basis of the pair of first output difference voltages, and outputs the first gate drive signal to the first switching element, and the second gate drive signal generation circuit may be a circuit that is electrically connected to the second differential amplifier circuit, generates a second gate drive signal being the gate drive signal based on a negative potential on a basis of the pair of second output difference voltages, and outputs the second gate drive signal to the second switching element.

According to this configuration, the first switching element and the second switching element push-pull connected to each other can be driven while the common mode noise superimposed on the output side and the input side is removed.

The gate drive signal generation circuit may be a circuit including a flip-flop that receives the pair of output difference voltages and outputs a single-ended signal based on a predetermined potential, the circuit configured to output the single-ended signal as the gate drive signal.

According to this configuration, the flip-flop can generate the gate drive signal that is a single-ended signal based on a predetermined potential. Furthermore, the waveforms of the pair of output difference voltages of the differential amplifier circuit can be shaped, and thus common mode noise can be further removed.

Hereinafter, specific embodiments of the present disclosure will be described with reference to the drawings. In the following description, the same or corresponding elements are denoted by the same reference signs throughout all the drawings, and redundant description of the elements will be omitted. The drawings described below are for describing the present disclosure, and therefore in the drawings, an element unrelated to the present disclosure may be omitted, a dimension may be inaccurate for exaggeration or the like, simplification may be performed, or the forms of elements corresponding to each other may be inconsistent in a plurality of drawings. The present disclosure is not limited to the following embodiments.

### (Embodiments)

First, a use environment of the gate drive circuit of the present disclosure will be described.

### [Use Environment]

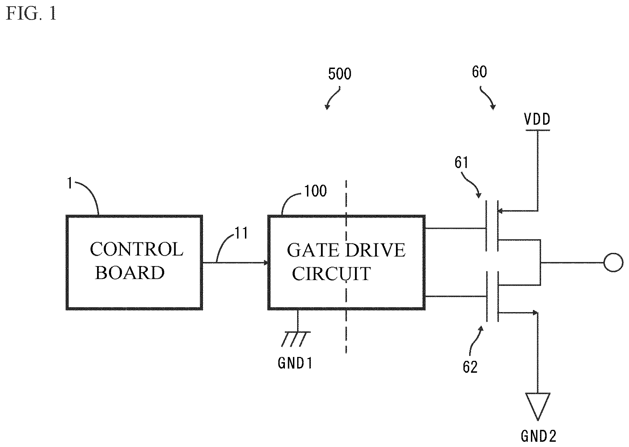

FIG. 1 is a circuit diagram illustrating a configuration of a push-pull amplifier circuit 500 using a gate drive circuit 100 of the present disclosure. Referring to FIG. 1, the push-pull amplifier circuit 500 includes a pair of switching elements 60 that are push-pull connected, and the gate drive circuit 100. The pair of switching elements 60 include a high-side first switching element 61 including, for example, a PMOSFET, and a low-side second switching element 62 including, for example, an NMOSFET so that the first switching element 61 and the second switching element 62 are connected in series between a positive power supply VDD and a second ground GND2, and an output is taken out from the connection point. In the gate drive circuit 100, the input side and the output side are insulated, the input side is connected to a first ground GND1, and the output side is electrically connected to the pair of switching elements 60. Therefore, the output side is in a floating state with respect to the first ground GND1 on the input side. The gate drive circuit 100 generates a gate drive signal from a gate control signal 11 input from a control board 1, and drives the pair of switching elements 60 by the gate drive signal. Next, a configuration of the gate drive circuit 100 will be described.

### [Configuration of Gate Drive Circuit 100]

1. First, a configuration of the gate drive circuit 100 will be summarized. The gate drive circuit 100 has first to third configuration examples.

### { Outline}

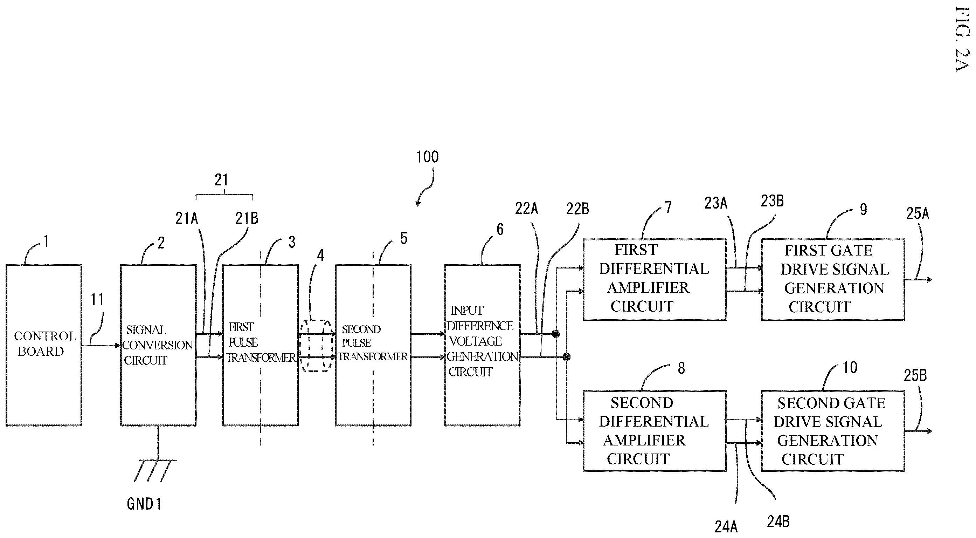

FIG. 2A is a block diagram illustrating the first configuration example of the gate drive circuit 100 of FIG. 1.

First, the first configuration example will be described. The first configuration example is a configuration example of the gate drive circuit 100 including a transmission cable 4 and a second pulse transformer. Referring to FIG. 2A, the gate drive circuit 100 includes a signal conversion circuit 2, a first pulse transformer 3, the transmission cable 4, a second pulse transformer 5, an input difference voltage generation circuit 6, a first differential amplifier circuit 7, a second differential amplifier circuit 8, a first gate drive signal generation circuit 9, and a second gate drive signal generation circuit 10.

The signal conversion circuit 2 operates with the potential of the first ground GND1 as a reference potential, and converts the gate control signal 11 that is a single-ended signal from the control board 1 into a differential signal 21 including a positive signal 21A and a negative signal 21B having a signal level difference corresponding to the gate control signal 11.

The first pulse transformer 3 transmits the differential signal 21 to the input difference voltage generation circuit 6 via the transmission cable 4 and the second pulse transformer 5. As a result, the input side and the output side of the gate drive circuit 100 are insulated by the first pulse transformer 3 and the second pulse transformer 5.

The input difference voltage generation circuit 6 generates a pair of input difference voltages 22A and 22B on the basis of the transmitted differential signal 21. The first differential amplifier circuit 7 differentially amplifies the pair of input difference voltages 22A and 22B and outputs a pair of first output difference voltages 23A and 23B having a high potential. The first gate drive signal generation circuit 9 generates a first gate drive signal 25A based on a predetermined positive potential on the basis of the pair of first output difference voltages 23A and 23B, and outputs the first gate drive signal 25A to the first switching element 61 (see FIG. 1). Meanwhile, the second differential amplifier circuit 8 differentially amplifies the pair of input difference voltages 22A and 22B, and outputs a pair of second output difference voltages 24A and 24B having a lower potential than the pair of first output difference voltages 23A and 23B. The second gate drive signal generation circuit 10 generates a second gate drive signal 25B based on a predetermined negative potential on the basis of the pair of second output difference voltages 24A and 24B, and outputs the second gate drive signal 25B to the second switching element 62 (see FIG. 1).

Such a first configuration example is applied in a case where the computer included in the control board (control device) 1 is desirably protected away from a generation source of common mode noise as much as possible.

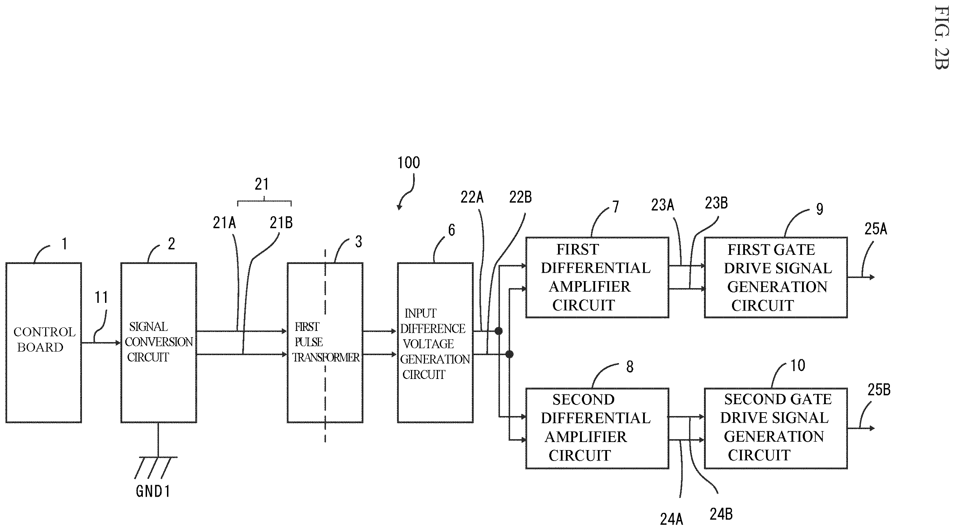

Next, the second configuration example will be described. FIG. 2B is a block diagram illustrating the second configuration example of the gate drive circuit 100 of FIG. 1. Referring to FIG. 2B, in the second configuration example, a transmission cable 4 and a second pulse transformer 5 are omitted. Thus, in the second configuration example, the input side and the output side of the gate drive circuit 100 are insulated by a first pulse transformer 3. An input difference voltage generation circuit 6 generates a pair of input difference voltages 22A and 22B on the basis of a differential signal 21 output to a secondary winding of the first pulse transformer 3. The configurations other than the above are the same as those in the first configuration example, and therefore the description thereof will be omitted. Such a second configuration example is applied in a case where the control board 1 does not need to be away from a generation source of common mode noise.

Next, the third configuration example will be described. In the third configuration example, the gate drive circuit 100 includes only one set of a differential amplifier circuit and a gate drive signal generation circuit (for example, a first differential amplifier circuit 7 and a first gate drive signal generation circuit 9, or a second differential amplifier circuit 8 and a second gate drive signal generation circuit 10). The configurations other than the above are the same as those in the first configuration example and the second configuration example, and therefore the description thereof will be omitted. Such a third configuration example is applied in the case of driving a single switching element (for example, the first switching element 61 or the second switching element 62 in FIG. 1).

Next, a detailed configuration and operation of the gate drive circuit 100 of the first configuration example of FIG. 2A will be described. In the second configuration example and the third configuration example, the elements of the first configuration example are merely omitted, and therefore the detailed description of the configurations and operations thereof will be omitted.

### {Detailed Configuration}

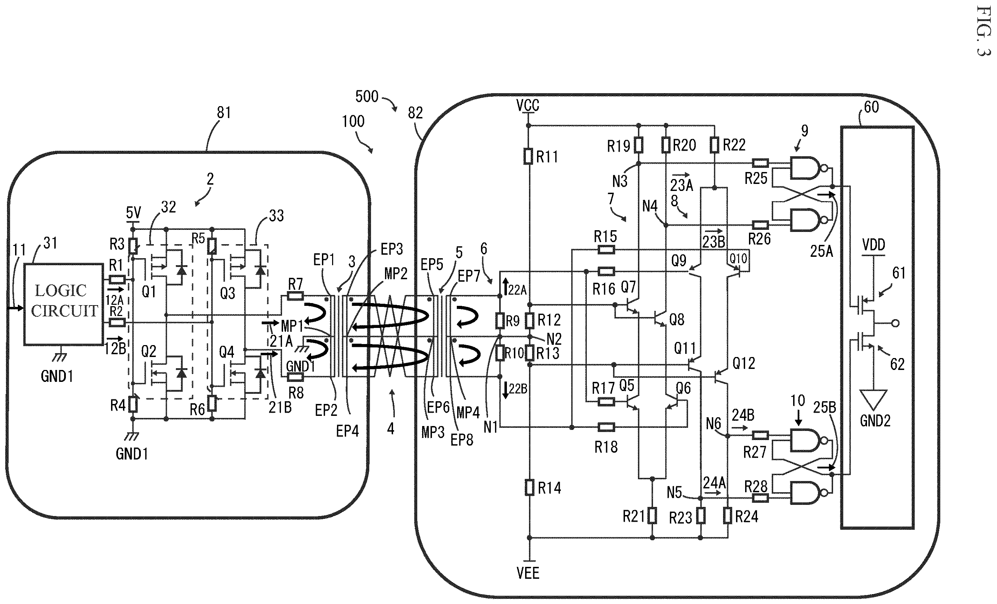

FIG. 3 is a circuit diagram illustrating an example of a specific circuit configuration of the first configuration example of the gate drive circuit 100 of FIG. 2A.

Referring to FIG. 3, the circuit illustrated in FIG. 3 includes the gate drive circuit 100 of FIG. 2A and the pair of push-pull connected switching elements 60 of FIG. 1, and thus the circuit illustrated in FIG. 3 is configured as a push-pull amplifier circuit 500.

The signal conversion circuit 2 includes a logic circuit 31, a positive signal generation circuit 32, and a negative signal generation circuit 33.

The logic circuit 31 generates an in-phase signal 12A and an anti-phase signal 12B from the gate control signal 11 from the control board 1, using a logic circuit.

The positive signal generation circuit 32 is formed by connecting a pair of push-pull connected transistors Q1 and Q2 to a positive power supply of 5 V and the first ground GND1 via resistance elements R3 and R4, respectively. Note that, to the pair of transistors Q1 and Q2, diodes facing in opposite directions are connected in parallel. The transistor Q1 and the transistor Q2 are constituted by, for example, a PMOSFET and an NMOSFET, and the in-phase signal 12A from the logic circuit 31 is input to the gates of the transistors Q1 and Q2 via a resistance element R1. As a result, the positive signal generation circuit 32 outputs a positive signal obtained by amplifying the in-phase signal 12A from the connection point between the transistor Q1 and the transistor Q2.

The negative signal generation circuit 33 is formed by connecting a pair of push-pull connected transistors Q3 and Q4 to a positive power supply of 5 V and the first ground GND1 via resistance elements R5 and R6, respectively. To the pair of transistors Q3 and Q4, diodes facing in opposite directions are connected in parallel. The transistor Q3 and the transistor Q4 are constituted by, for example, a PMOSFET and an NMOSFET, and the anti-phase signal 12B from the logic circuit 31 is input to the gates of the transistors Q3 and Q4 via a resistance element R2. As a result, the negative signal generation circuit 33 outputs the negative signal 21B obtained by amplifying the anti-phase signal 12B from the connection point between the transistor Q3 and the transistor Q4.

The first pulse transformer 3 includes a primary winding and a secondary winding that are electrically insulated from each other and have neutral points MP1 and MP2, respectively. The neutral point MP1 of the primary winding is connected to the first ground GND1. The primary winding has a first end EP1 connected to the connection point between the transistor Q1 and the transistor Q2 of the positive signal generation circuit 32, and the first end EP1 receives the positive signal 21A. The primary winding has a second end EP2 connected to the connection point between the transistor Q3 and the transistor Q4 of the negative signal generation circuit 33, and the second end EP2 receives the negative signal 21B.

The second pulse transformer 5 includes a primary winding and a secondary winding that are electrically insulated from each other and have neutral points MP3 and MP4, respectively. The primary winding has a first end EP5, a second end EP6, and the neutral point MP3 that are respectively connected to a first end EP3, a second end EP4, and a neutral point MP2 of the secondary winding of the first pulse transformer 3 via the transmission cable 4.

The input difference voltage generation circuit 6 includes a pair of resistance elements R9 and R10 connected in series to each other. The pair of resistance elements R9 and R10 have appropriate resistance values equal to each other. The resistance values of the pair of resistance elements R9 and R10 are preferably equal to each other from the viewpoint of completely canceling the common mode noise. However, the resistance values of the pair of resistance elements R9 and R10 may be unequal to each other. Even in this case, the common mode noise can be reduced although the reduction is incomplete. The pair of resistance elements R9 and R10 have an end on the high potential side, an end on the low potential side, and their connection point N1 that are connected to a first end EP7, a second end EP8, and a neutral point MP4 of the secondary winding of the second pulse transformer 5, respectively. As a result, a pair of input difference voltages 22A and 22B based on the potential at the connection point N1 are generated at both ends of the pair of resistance elements R9 and R10.

The first differential amplifier circuit 7 includes a pair of transistors Q5 and Q6 as amplification elements. One transistor Q5 is connected to a positive power supply VCC via a transistor Q7 and a resistance element R19, and is connected to a negative power supply VEE via a common resistance element R21. The other transistor Q6 is connected to the positive power supply VCC via a transistor Q8 and a resistance element R20, and is connected to the negative power supply VEE via the common resistance element R21. The pair of transistors Q5 and Q6 are constituted by, for example, npn bipolar transistors. The base of the transistor Q5 is connected to the end on the high potential side of the pair of resistance elements R9 and R10 via a base resistance element R17, and the base of the transistor Q5 receives the input difference voltage 22A (high potential side difference voltage). The base of the transistor Q6 is connected to the end on the low potential side of the pair of resistance elements R9 and R10 via a base resistance element R18, and the base of the transistor Q6 receives the input difference voltage 22B (low potential side difference voltage).

In the gate drive circuit 100, a circuit is formed that divides the voltage between the positive power supply VCC and the negative power supply VEE by resistance. In this circuit, for example, four resistance elements R11 to R14 are connected in series between the positive power supply VCC and the negative power supply VEE, and the resistance element R11 and the resistance element 14 have the same resistance value, and the resistance element R12 and the resistance element R13 have the same resistance value. As a result, a connection point N2 between the resistance element R12 and the resistance element R13 has an intermediate potential between the positive power supply VCC and the negative power supply VEE, and the connection point N2 is connected to the connection point N1 of the input difference voltage generation circuit 6. As a result, the potential of the connection point N1 is fixed by the positive power supply VCC and the negative power supply VEE, but this configuration may be omitted.

The bases of the transistors Q7 and Q8 are connected to the connection point between the resistance element R11 and the resistance element R12, and the resistance values of these resistance elements R11 and R12 are appropriately selected so that the transistors Q7 and Q8 have predetermined high resistance values.

With the above configuration, the first differential amplifier circuit 7 differentially amplifies the pair of input difference voltages 22A and 22B and outputs the pair of first output difference voltages 23A and 23B to a connection point N3 and a connection point N4, respectively.

The second differential amplifier circuit 8 includes a pair of transistors Q9 and Q10 as amplification elements. One transistor Q9 is connected to the positive power supply VCC via a common resistance element R22, and is connected to the negative power supply VEE via a transistor Q11 and a resistance element R23. The other transistor Q10 is connected to the positive power supply VCC via the common resistance element R22, and is connected to the negative power supply VEE via a transistor Q12 and a resistance element R24. The pair of transistors Q9 and Q10 are constituted by, for example, pnp bipolar transistors. The base of the transistor Q9 is connected to the end on the high potential side of the pair of resistance elements R9 and R10 via a base resistance element R16, and the base of the transistor Q9 receives the input difference voltage 22A (high potential side difference voltage). The base of the transistor Q10 is connected to the end on the low potential side of the pair of resistance elements R9 and R10 via a base resistance element R15, and the base of the transistor Q9 receives the input difference voltage 22B (low potential side difference voltage).

The bases of the transistors Q11 and Q12 are connected to the connection point between the resistance element R13 and the resistance element R14, and the resistance values of these resistance elements R13 and R14 are appropriately selected so that the transistors Q11 and Q12 have predetermined high resistance values.

With the above configuration, the second differential amplifier circuit 8 differentially amplifies the pair of input difference voltages 22A and 22B and outputs the pair of second output difference voltages 24A and 24B to a connection point N5 and a connection point N6, respectively.

The first gate drive signal generation circuit 9 is constituted by a rectangular wave waveform shaping circuit. As the waveform shaping circuit, for example, an RS flip-flop, which is a logic circuit, is used. The RS flip-flop operates with a predetermined high potential as a reference. In the RS flip-flop, for example, a set input terminal is connected to the connection point N3 via a resistance element R25, a reset input terminal is connected to the connection point N4 via a resistance element R26, and a set output terminal is connected to the gate of the first switching element 61. The set input terminal and the reset input terminal receive the pair of first output difference voltages 23A and 23B including single-ended signals having opposite phases, so that to the set output terminal, a single-ended signal having the same phase as the first output difference voltage 23A is output. The first gate drive signal generation circuit 9 outputs the single-ended signal as the first gate drive signal 25A to the first switching element 61.

The second gate drive signal generation circuit 10 is constituted by a rectangular wave waveform shaping circuit. As the waveform shaping circuit, for example, an RS flip-flop, which is a logic circuit, is used. The RS flip-flop operates with a predetermined low potential as a reference. In the RS flip-flop, for example, a set input terminal is connected to the connection point N5 via a resistance element R28, a reset input terminal is connected to the connection point N6 via a resistance element R27, and a set output terminal is connected to the gate of the second switching element 62. The set input terminal and the reset input terminal receive the pair of second output difference voltages 24A and 24B including single-ended signals having opposite phases, so that to the set output terminal, a single-ended signal having the same phase as the second output difference voltage 24A is output. The second gate drive signal generation circuit 10 outputs the single-ended signal as the second gate drive signal 25B to the second switching element 62.

As the waveform shaping circuit, another rectangular wave shaping circuit may be used.

### [Operation of Gate Drive Circuit 100]

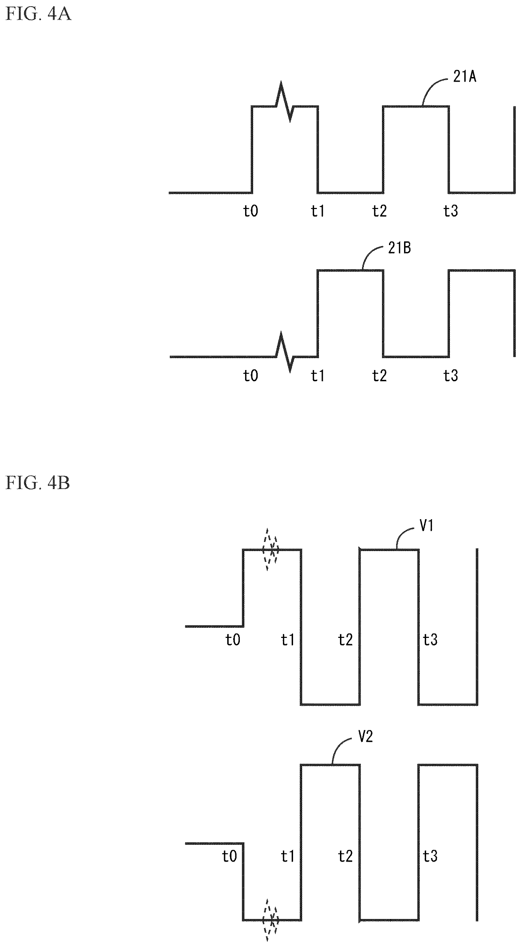

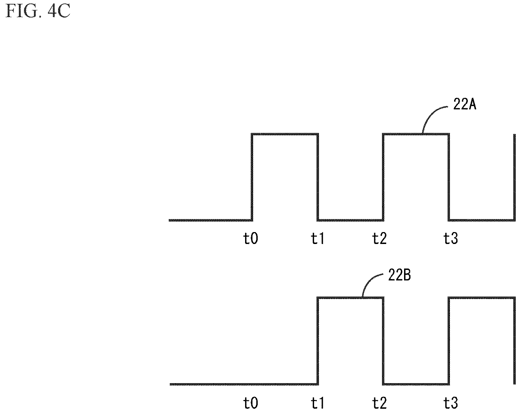

Next, the operation of the gate drive circuit 100 configured as described above will be described with reference to FIG. 3 and FIGS. 4A to 4C. FIG. 4A is a waveform diagram illustrating the waveform of the differential signal 21 on which common mode noise is superimposed. The upper waveform diagram in FIG. 4A illustrates the waveform of the positive signal 21A, and the lower waveform diagram in FIG. 4A illustrates the waveform of the negative signal 21B. FIG. 4B is a waveform diagram illustrating the waveform of the differential signal 21 induced in the first pulse transformer 3 by the differential signal 21 of FIG. 4A. FIG. 4C is a waveform diagram illustrating the waveform of the input difference voltages 22A and 22B generated by the input difference voltage generation circuit 6 from a signal derived from the differential signal 21 induced in the first pulse transformer 3 of FIG. 4B.

Referring to FIG. 3, the logic circuit 31 generates the in-phase signal 12A and the anti-phase signal 12B from the gate control signal 11 from the control board 1. The positive signal generation circuit 32 outputs the positive signal 21A obtained by amplifying the in-phase signal 12A. The negative signal generation circuit 33 outputs the negative signal 21B obtained by amplifying the anti-phase signal 12B. The positive signal 21A and the negative signal 21B are input to the first end EP1 and the second end EP2 of the primary winding of the first pulse transformer 3, respectively.

Referring to FIG. 4A, here, the positive signal 21A and the negative signal 21B are each a single-ended signal having a binary value of a high level of a positive voltage (5 V) and a low level of 0 voltage (potential of the first ground GND1 of 0 V), and have phases opposite to each other. At a time of t0, the positive signal 21A and the negative signal 21B are input to the first end EP1 and the second end EP2 of the primary winding, respectively.

In the first half cycle of the positive signal 21A and the negative signal 21B, at the time of t0 in the primary winding of the first pulse transformer, the positive voltage of the positive signal 21A is applied to the first end EP1 and 0 voltage of the negative signal 21B is applied to the second end EP2, so that the excitation current flows from the first end EP1 toward the neutral point MP1. Referring to FIG. 4B, thus, the voltage from the second end EP2 toward the first end EP1 is induced in the primary winding of the first pulse transformer 3. In this case, the potential at the neutral point MP1 of the primary winding is 0 V, so that the voltage V1 at the first end EP1 is a positive voltage. Meanwhile, at the time of t0, the second end EP2 is connected to the first ground GND1 via a resistance element R8, so that the voltage V2 of the second end EP2 is a negative voltage, and the current flows from the neutral point MP1 toward the second end EP2. At this time, the excitation current induces a voltage corresponding to the turn ratio of the first pulse transformer 3 and the second pulse transformer 5 in the secondary winding of the first pulse transformer 3 and the primary winding and the secondary winding of the second pulse transformer 5.

In the next half cycle of the positive signal 21A and the negative signal 21B, inversely to the above, at the time of t1 in the primary winding of the first pulse transformer 3, 0 voltage of the positive signal 21A is applied to the first end EP1 and the positive voltage of the negative signal 21B is applied to the second end EP2, so that the excitation current flows from the second end EP2 toward the neutral point MP1. Thus, the voltage from the first end EP1 toward the second end EP2 is induced in the primary winding of the first pulse transformer 3. In this case, the potential at the neutral point MP1 of the primary winding is 0 V, so that the voltage V2 at the second end EP2 is a positive voltage. Meanwhile, at the time of t1, the first end EP1 is connected to the first ground GND1 via a resistance element R7, so that the voltage V1 of the first end EP1 is a negative voltage, and the current flows from the neutral point MP1 toward the first end EP1. At this time, the excitation current induces a voltage corresponding to the turn ratio of the first pulse transformer 3 and the second pulse transformer 5 in the secondary winding of the first pulse transformer 3 and the primary winding and the secondary winding of the second pulse transformer 5. Thereafter (t2, t3, ···), the above one cycle is repeated.

Thus, the positive signal 21A and the negative signal 21B are converted into a pair of single-ended voltage signals that have the voltage V1 and the voltage V2 having twice the amplitude, respectively, and have opposite phases (opposite in positive and negative) in the first pulse transformer 3, and are transmitted to the secondary winding of the second pulse transformer 5 via the transmission cable 4.

Here, the action of removing common mode noise on the input side of the gate drive circuit 100 will be described. Referring to FIG. 4A, for example, it is assumed that common mode noise is superimposed on each of the positive signal 21A and the negative signal 21B between the time t0 and the time t1. Referring to FIG. 3, the common mode noise superimposed on the positive signal 21A causes an excitation current flow between the first end EP1 and the neutral point MP1 of the primary winding of the first pulse transformer 3, and the common mode noise superimposed on the negative signal 21B causes an excitation current flow between the second end EP2 and the neutral point MP1 of the primary winding of the first pulse transformer 3. However, as illustrated in FIG. 4B, the two excitation currents are in opposite directions to each other, so that voltages opposite in positive and negative to each other are induced in the primary winding, and cancel each other. Thus, the common mode noise superimposed on the positive signal 21A and the negative signal 21B is removed from the pair of single-ended voltage signals obtained by conversion from the positive signal 21A and the negative signal 21B in the first pulse transformer 3. The common mode noise superimposed on the transmission cable 4 is also removed from the pair of single-ended voltage signals by an action similar to the above-described action in the second pulse transformer 5.

Referring to FIG. 3, in the input difference voltage generation circuit 6, the input difference voltages 22A and 22B are generated from the pair of single-ended voltage signals transmitted to the secondary winding of the second pulse transformer 5 as follows. Referring to FIG. 4C, a single-ended voltage signal corresponding to the voltage V1 of FIG. 4B appears at the end on the high potential side of the resistance element R9, and this single-ended voltage signal has a waveform as illustrated in the upper part of FIG. 4C because the intermediate voltage of amplitude thereof is at a low level of 0 voltage based on the connection point N2. Meanwhile, a single-ended voltage signal corresponding to the voltage V2 of FIG. 4B appears at the end on the low potential side of the resistance element R10, and this single-ended voltage signal has a waveform as illustrated in the lower part of FIG. 4C because the intermediate voltage of amplitude thereof is at a low level of 0 voltage based on the connection point N2. Therefore, the pair of input difference voltages 22A and 22B have waveforms corresponding to the positive signal 21A and the negative signal 21B of FIG. 4A, respectively.

In the input difference voltage generation circuit 6, the load current of the second pulse transformer 5 flows through the pair of resistance elements R9 and R10, so that the corresponding load current also flows in the first pulse transformer 3. FIG. 3 illustrates the current in the transmission path of the differential signal 21 in the case of the positive signal 21A at a high level. As a result, the first pulse transformer 3 and the second pulse transformer 5 has a low impedance, so that a large current can flow through the transmission path of the differential signal 21 including the first pulse transformer 3, the transmission cable 4, and the second pulse transformer 5, and thus the capability to remove common mode noise can be improved on the input side of the gate drive circuit 100.

Referring FIG. 3, in a case where common mode noise is superimposed on a pair of wirings from the secondary winding of the second pulse transformer 5 to the first and the second differential amplifier circuits 7 and 8, the common mode noise of the pair of wirings is opposite in positive and negative in the pair of input difference voltages 22A and 22B generated by the input difference voltage generation circuit 6. The first and the second differential amplifier circuits 7 and 8 differentially amplify the pair of input difference voltages 22A and 22B, and thus the superimposed common mode noise is removed.

An aspect of the wiring from the secondary winding of the second pulse transformer 5 to the first and the second differential amplifier circuits 7 and 8 may cause a slight deviation between the timings at which the pair of input difference voltages 22A and 22B are input to the first and the second differential amplifier circuits 7 and 8 respectively, and in a case where the first and the second differential amplifier circuits 7 and 8 operate at a high speed, the common mode noise may be not completely removed due to the slight deviation between the timings. However, the first and the second gate drive signal generation circuits 9 and 10 constituted by the waveform shaping circuits shape the waveforms of the pair of first output difference voltages 23A and 23B and the pair of second output difference voltages 24A and 24B output from the first and the second differential amplifier circuits 7 and 8 respectively, and thus the residual component of the common mode noise is removed from the pair of first output difference voltages 23A and 23B and the pair of second output difference voltages 24A and 24B. In particular, a waveform shaping circuit that is a flip-flop suitably removes the noise obtained by converting the common mode noise into the normal mode in the preceding circuit. Thus, the common mode noise is removed on the output side of the gate drive circuit 100.

### [Mounting on Board]

Referring to FIG. 3, in the push-pull amplifier circuit 500, the signal conversion circuit 2 and the first pulse transformer 3 are mounted on a first board 81, and the second pulse transformer 5, the input difference voltage generation circuit 6, the first differential amplifier circuit 7, the second differential amplifier circuit 8, the first gate drive signal generation circuit 9, the second gate drive signal generation circuit 10, and the pair of switching elements 60 are mounted on a second board 82. The secondary winding of the first pulse transformer 3 of the first board 81 and the primary winding of the second pulse transformer 5 of the second board 82 are connected by the transmission cable 4.

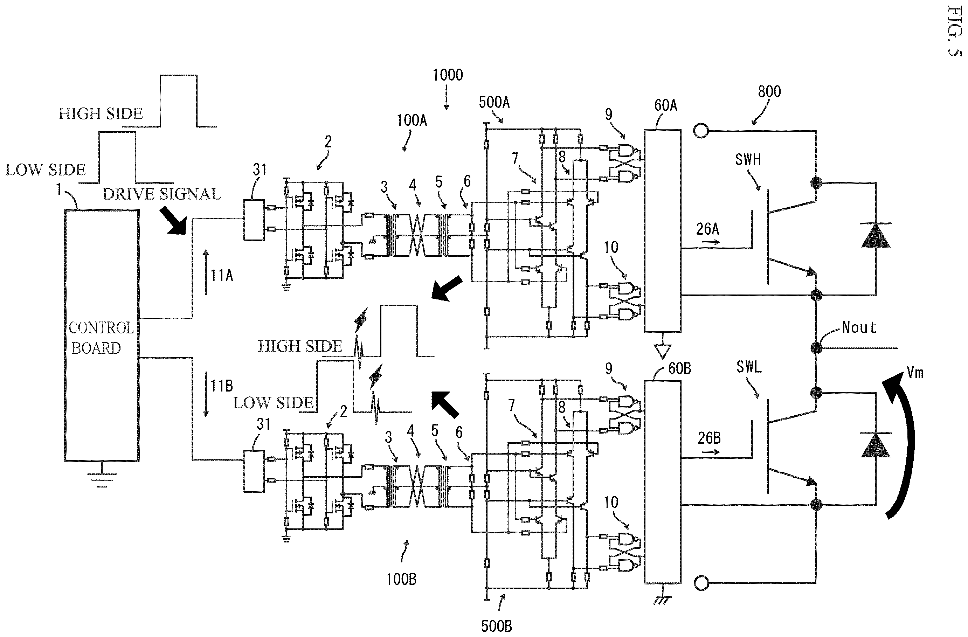

Therefore, the computer included in the control board 1 can be suitably protected from the common mode noise generated by the switching operation of a switching module 800 by, for example, disposing the second board 82 in the vicinity of the switching module 800 driven by the pair of switching elements 60 (see FIG. 5), extending the transmission cable 4, and disposing the first board 81 in the vicinity of the control board 1 away from the switching module 800.

### [Application to Switching Power Supply]

FIG. 5 is a circuit diagram illustrating an operation of a switching power supply 1000 using the push-pull amplifier circuit 500 of FIG. 3. In FIG. 3, reference signs of detailed elements are omitted for ease of illustration.

Referring to FIG. 5, the switching power supply 1000 includes the switching module 800 and first and second push-pull amplifier circuits 500A and 500B. The switching module 800 includes a high-side switching element SWH and a low-side switching element SWL. The high-side switching element SWH and the low-side switching element SWL are constituted by, for example, IGBTs. To each of the high-side switching element SWH and the low-side switching element SWL, a reverse diode is connected in parallel.

The first push-pull amplifier circuit 500A includes a first gate drive circuit 100A and a first pair of switching elements 60A. The second push-pull amplifier circuit 500B includes a second gate drive circuit 100B and a second pair of switching elements 60B.

The high-side switching element SWH is connected to the first pair of switching elements 60A of the first push-pull amplifier circuit 500A, and the gate of the high-side switching element SWH receives the output of the first pair of switching elements 60A. The low-side switching element SWL is connected to the second pair of switching elements 60B of the second push-pull amplifier circuit 500B, and the gate of the low-side switching element SWL receives the output of the second pair of switching elements 60B. The control board 1 and the signal conversion circuits 2 of the first and the second gate drive circuits 100A and 100B are grounded. The first pair of switching elements 60A are connected to the frame ground, and the second pair of switching elements 60B are connected to the signal ground.

In the switching power supply 1000 configured as described above, a high-side gate control signal 11A is input from the control board 1 to the logic circuit 31 of the first gate drive circuit 100A. Then, the first gate drive circuit 100A generates first and second gate drive signals, and thus a high-side gate drive signal 26A is output from the first pair of switching elements 60A to the gate of the high-side switching element SWH. Meanwhile, a low-side gate control signal 11B is input from the control board 1 to the logic circuit 31 of the second gate drive circuit 100B. Then, the second gate drive circuit 100B generates first and second gate drive signals, and thus a low-side gate drive signal 26B is output from the second pair of switching elements 60B to the gate of the low-side switching element SWL. As illustrated in FIG. 5, the high-side gate control signal 11A and the low-side gate control signal 11B are shifted from each other.

As a result, the high-side switching element SWH and the low-side switching element SWL are turned on and off at different timings, and the control power of the switching module 800 is output from a connection point Nout between the high-side switching element SWH and the low-side switching element SWL.

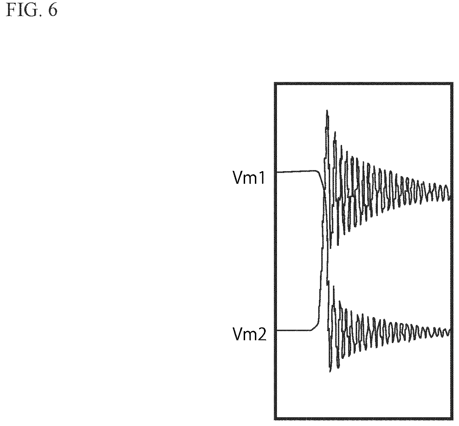

Turning on and off each of the high-side switching element SWH and the low-side switching element SWL fluctuates the voltage (potential) Vm at the connection point Nout. The fluctuation of the voltage Vm at the connection point Nout generates switching noise as illustrated in FIG. 6. FIG. 6 is a schematic diagram illustrating switching noise generated by the switching module 800 of FIG. 5. In FIG. 6, Vm1 indicates a voltage fluctuation at the connection point Nout in a case where the low-side switching element SWL is turned on when the high-side switching element SWH is turned off, and Vm2 indicates a voltage fluctuation at the connection point Nout in a case where the low-side switching element SWL is turned off when the high-side switching element SWH is turned on. FIG. 6 illustrates that the voltage fluctuation Vm1 and the voltage fluctuation Vm2 occur at the same timing for convenience although the voltage fluctuation Vm1 and the voltage fluctuation Vm2 occur at different timings. Note that FIG. 6 has been created by tracing the waveform images of the voltages actually obtained, and the waveforms are not accurate.

If the voltage Vm (Vm1, Vm2) at the connection point Nout fluctuates as illustrated in FIG. 6, switching noise is radiated (emitted) from the connection point Nout. Then, this switching noise is superimposed as common mode noise on the wirings of the first and the second gate drive circuits 100A and 100B. However, the common mode noise superimposed on the wirings of the first and the second gate drive circuits 100A and 100B is removed as described above.

As described above, the gate drive circuit 100 of the present disclosure can remove common mode noise superimposed on the output side and the input side. Furthermore, the computer included in the control board 1 can be suitably protected from the common mode noise generated by the switching operation of the switching module 800.

From the above description, many modifications and other embodiments are apparent to those skilled in the art. Therefore, the above description is to be interpreted only as an example.

### Industrial Applicability

The gate drive circuit of the present invention is useful as a gate drive circuit that can remove common mode noise superimposed on the output side and the input side.

### Reference Signs List

- 1: control board
- 2: signal conversion circuit
- 3: first pulse transformer
- 4: transmission cable
- 5: second pulse transformer
- 6: input difference voltage generation circuit
- 7: first differential amplifier circuit
- 8: second differential amplifier circuit
- 9: first gate drive signal generation circuit
- 10: second gate drive signal generation circuit
- 11: gate control signal
- 12A: in-phase signal
- 12B: anti-phase signal
- 21: differential signal
- 21A: positive signal
- 21B: negative signal
- 22A, 22B: input difference voltage
- 23A, 23B: first output difference voltage
- 24A, 24B: second output difference voltage
- 25A: first gate drive signal
- 25B: second gate drive signal
- 26A: high-side gate drive signal
- 26B: low-side gate drive signal
- 31: logic circuit
- 32: positive signal generation circuit
- 33: negative signal generation circuit
- 60: pair of switching elements
- 61: first switching element
- 62: second switching element
- 81: first board
- 82: second board
- 100: gate drive circuit
- 500: push-pull amplifier circuit
- 800: switching module
- 1000: switching power supply
- GND1: first ground
- GND2: second ground

## Claims

1. A gate drive circuit comprising:
a signal conversion circuit configured to operate with a potential of a first ground as a reference potential and convert a gate control signal that is a single-ended signal into a differential signal including a positive signal and a negative signal that have a signal level difference corresponding to the gate control signal;
a first pulse transformer including a primary winding and a secondary winding that are electrically insulated from each other and have neutral points respectively, the primary winding including the neutral point set to have the potential of the first ground, the primary winding having both ends to which the positive signal and the negative signal of the differential signal are input respectively;
an input difference voltage generation circuit including a pair of resistance elements connected in series to each other, the pair of resistance elements having both ends and a connection point that are respectively connected to both ends and the neutral point of the secondary winding of the first pulse transformer directly electrically or via a transmission cable and a second pulse transformer, the input difference voltage generation circuit configured to generate a pair of input difference voltages based on a potential of the connection point at the both ends of the pair of resistance elements;
a differential amplifier circuit that is electrically connected to the input difference voltage generation circuit, the differential amplifier circuit configured to differentially amplify the pair of input difference voltages and output a pair of output difference voltages; and
a gate drive signal generation circuit that is electrically connected to the differential amplifier circuit, the gate drive signal generation circuit configured to generate a gate drive signal that is a single-ended signal based on a predetermined potential on a basis of the pair of output difference voltages and output the gate drive signal to a switching element that operates with a potential of a second ground as a reference.

2. The gate drive circuit according to claim 1, wherein
the second pulse transformer includes a primary winding and a secondary winding that are electrically insulated from each other and have neutral points respectively, the primary winding having both ends and the neutral point that are respectively connected to the both ends and the neutral point of the secondary winding of the first pulse transformer electrically via the transmission cable, and
in the input difference voltage generation circuit, the both ends and the connection point of the pair of resistance elements are respectively connected to the both ends and the neutral point of the secondary winding of the second pulse transformer.

3. The gate drive circuit according to claim 1 or 2, wherein
two of the switching elements constitute a first switching element and a second switching element that are push-pull connected to each other,
The gate drive circuit comprises a first differential amplifier circuit and a second differential amplifier circuit as the differential amplifier circuit,
The gate drive circuit comprises a first gate drive signal generation circuit and a second gate drive signal generation circuit as the gate drive signal generation circuit,
the first differential amplifier circuit is a circuit that is electrically connected to the input difference voltage generation circuit, differentially amplifies the pair of input difference voltages, and outputs a pair of first output difference voltages having a high potential,
the second differential amplifier circuit is a circuit that is electrically connected to the input difference voltage generation circuit, differentially amplifies the pair of input difference voltages, and outputs a pair of second output difference voltages lower than the pair of first output difference voltages and having a low potential,
the first gate drive signal generation circuit is a circuit that is electrically connected to the first differential amplifier circuit, generates a first gate drive signal being the gate drive signal based on a positive potential on a basis of the pair of first output difference voltages, and outputs the first gate drive signal to the first switching element, and
the second gate drive signal generation circuit is a circuit that is electrically connected to the second differential amplifier circuit, generates a second gate drive signal being the gate drive signal based on a negative potential on a basis of the pair of second output difference voltages, and outputs the second gate drive signal to the second switching element.

4. The gate drive circuit according to claims 1 to 3, wherein the gate drive signal generation circuit is a circuit including a flip-flop that receives the pair of output difference voltages and outputs a single-ended signal based on a predetermined potential, the circuit configured to output the single-ended signal as the gate drive signal.
